# EUROPEAN PATENT APPLICATION

(11) **EP 3 862 779 A1**
(43) Date of publication of application: **11.08.2021**
(21) Application number: 20156049.7
(22) Date of filing: 07.02.2020
(51) Int. Cl.: G01S 7/481, G01S 7/484, G01S 17/10, G01S 17/42

(54) **A LIDAR SENSOR ARRANGEMENT**

(71) Applicant: Veoneer Sweden AB, 447 37 Vårgårda (SE)
(72) Inventor: Marklund, Anders, 931 57 Skellefteå (SE); Kristoffersson, Tord, 931 57 Skellefteå (SE); Ranggård, Ulf, 931 57 Skellefteå (SE); Kröger, Niklas, 931 57 Skellefteå (SE)
(74) Representative: Westpatent AB

(57) **Abstract**

The present disclosure relates to a Lidar sensor system (10) comprising a laser diode device (11) and further electrical components (17), and also comprising a carrier element (12) for supporting said laser diode device (11) and said further electrical components (17), said carrier element (12) being provided with two contact surfaces (15, 16) which are associated with two corresponding contact terminals (13, 14) forming part of said laser diode device (11). Furthermore, according to the disclosure, the laser diode device (11) is configured so that said contact terminals (13, 14) are positioned on each side of said laser diode device (11), and so that each one of said contact terminals (13, 14) is mounted to and electrically connected to a corresponding one of said contact surfaces (15, 16). The disclosure also relates to a method for manufacturing a Lidar sensor system (10).

## Description

The present disclosure relates to a Lidar sensor system comprising a laser diode device and further electrical components, and also comprising a carrier element for supporting said laser diode device and said further electrical components. The carrier element is provided with two contact surfaces which are associated with two corresponding contact terminals forming part of said laser diode device.

The disclosure also relates to a method for manufacturing a Lidar sensor system having a laser diode device and further electrical components. The method comprises the following steps: providing a carrier element for supporting said laser diode device and said further electrical components; and providing two contact surfaces on said carrier element which are associated with two corresponding contact terminals forming part of said laser diode device.

Today, there exist different types of sensor systems by means of which various objects in the surroundings of the sensor system can be detected and analyzed.

As an example, it can be noted that such sensor systems can be used in road vehicles for detecting obstacles and other objects, such as for example in the form of approaching vehicles, road signs and lane markings. This means that vehicles can be equipped with such sensor systems which can be used with autonomous systems for navigation, speed control and for prevention of collisions.

According to known technology, so-called Lidar sensor systems can be used for the above-mentioned purposes. A Lidar sensor system can be based on a laser diode device which is configured for emitting laser light so as to illuminate a target area. The sensor system is further configured for measuring light which is reflected off any obstacle by means of a detector unit. In this manner, the occurrence of obstacles can be determined and analysed.

Normally, a Lidar sensor system is arranged so that laser light pulses are swept over a target area, after which the reflected light pulses in the sensor system's field of view are detected and processed. From this information, the target surface can be detected and analyzed so that obstacles and other features in the terrain can be detected.

A Lidar sensor system may comprise a laser diode device which for example may have a wavelength of 600-1000 nm. The laser diode device can be in the form of a bare die laser diode, i.e. a laser diode which is not encapsulated and which is consequently free from an enclosure or packaging, such as an enclosure of an epoxy material. Consequently, the laser diode is in this case a bare component which is mounted together with other components such as a power supply, signal treatment components, detector units etc. which form part of the complete sensor system. Such an arrangement leads to certain advantages such as an improved integration, an improved size reduction and a potential for improved electrical performance.

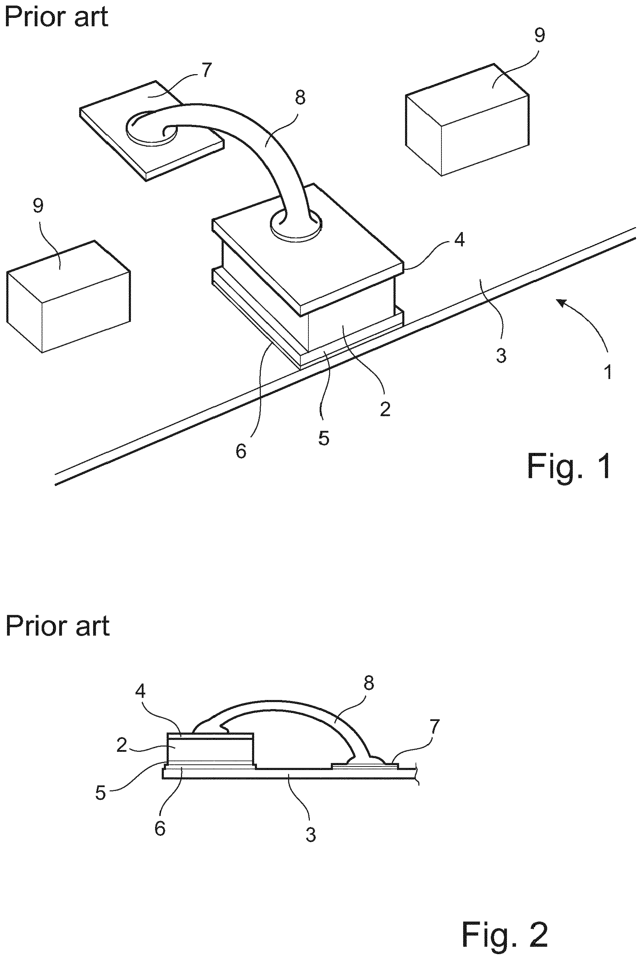

Figure 1 shows a part of a Lidar sensor system 1 in accordance with prior art, and also shows the manner in which a bare die laser diode device 2 can be mounted and connected on a printed circuit board 3 and used in the sensor system 1.

As shown in Figure 1 and also in Figure 2, which is a side view of the laser diode device 2 in accordance with prior art, it can be noted that the laser diode device 2 is shaped generally with a cube- or box-shaped design and is provided with a top terminal 4 and a bottom terminal 5. The laser diode device 2 is generally formed according to the state of the art, i.e. with the terminals 4, 5 being formed as thin conductive layers on the top and bottom end surfaces, respectively, of the laser diode device 2.

The bottom terminal 5 is positioned on, and soldered to, a contact surface 6 forming part of the printed circuit board 3, whereas the top terminal 4 is electrically connected to a further contact surface 7 of the printed circuit board 3 via a bond wire 8. To this end, the bond wire 8 is suitably soldered both to the top terminal 4 and to the further contact surface 7.

The above-mentioned arrangement is a known way of arranging a bare die laser diode 2 in a Lidar sensor system 1 together with various other electrical components 9, for example a detector unit, power supply and also discrete components such as for example resistors and capacitors.

Although the arrangement described above is a well-functioning sensor system based on Lidar technology, there is a need for further improvements within this field of technology. In particular, there is a demand for improvements regarding size reduction, increased integration of hardware and improved electrical properties.

### SUMMARY

For the above-mentioned reasons, it is an object of the present disclosure to provide an improved Lidar sensor system by means of which the above-mentioned drawbacks and challenges related to the prior art can be solved. In particular, there is a desire to obtain an improved heat dissipation of the components of the sensor system while improving its electrical properties, such as minimizing stray inductance which may occur in such a sensor system.

In accordance with the disclosure, said object is achieved by means of a Lidar sensor system comprising a laser diode device and further electrical components, and also comprising a carrier element for supporting said laser diode device and said further electrical components, said carrier element being provided with two contact surfaces which are associated with two corresponding contact terminals forming part of said laser diode device, Furthermore, the laser diode device is configured so that said contact terminals are positioned on each side of said laser diode device, and that each one of said contact terminals is mounted to and electrically connected to a corresponding one of said contact surfaces.

A number of advantages are obtained by means of the arrangement according to the present disclosure. Firstly, it can be noted that certain improvements related to reduced size and improved compactness of the carrier element can be obtained. Furthermore, the arrangement involving the laser diode device, having its contact terminals on its side surfaces, will produce an increased contact surface area of the laser diode device - for dissipating generated heat - than previously known.

The solution according to the disclosure will also generate less stray inductance than the previously known solution involving a soldered bond wire, which will enable certain further components, such as drive electronics, to be placed closer to the laser diode device. In this manner, a current loop length can be reduced.

In particular, minimizing the current loop and stray inductance while maximizing the heat dissipation is advantageous when using pulsed high power bare die laser diodes.

In order to actuate a laser diode device with short pulses (typically less than 1 ns) with a high power level, which is common in a Lidar sensor system, it is necessary to minimize the amount of stray inductance as much as possible and by using the laser in a bare die version, the silicon material which constitutes the laser device can be accessed.

In summary, the above-mentioned improved properties will lead to a more compact and space-saving sensor system with an improved heat dissipation and shorter high power pulse widths.

Additionally, the Lidar sensor system according to the disclosure can be integrated in a cost-effective manner in a so-called pick-and-place soldering process during its manufacturing.

The Lidar sensor system according to the disclosure is suitably used with a road vehicle such as a car, truck or other road vehicle, but can also in principle be used with any other vehicle being adapted for mounting a sensor system onboard the vehicle.

Other aspects of the present disclosure are disclosed in the dependent claims.

According to some of the aspects of the disclosure, the contact terminals are positioned on each side of a generally vertical plane extending along a longitudinal direction through the laser diode device.

According to some aspects, the laser diode device has a square or rectangular cross-section as regarded along a generally vertical plane extending along a transversal direction through the laser diode device.

According to some aspects, the contact terminals are configured as layers being oriented along a generally vertical direction.

According to some aspects, the contact terminals are electrically connected to said contact surfaces by means of soldering, such that each contact terminal is soldered to a corresponding contact surface.

According to some aspects, said carrier element is a printed circuit board.

According to some aspects, said laser diode device is a bare die laser diode.

In accordance with the disclosure, the above-mentioned object is also achieved by means of a method for producing a Lidar sensor having a laser diode device and further electrical components, said method comprising the following steps: providing a carrier element for supporting said laser diode device and said further electrical components; and providing two contact surfaces on said carrier element which are associated with two corresponding contact terminals forming part of said laser diode device. Furthermore, the method comprises the following steps: arranging said contact surfaces in a manner to be electrically connected to a corresponding one of said contact terminals; and configuring said laser diode device so that said contact terminals are positioned on each side of said laser diode device.

### BRIEF DESCRIPTION OF THE DRAWINGS

The present disclosure will now be described more in detail with reference to the appended drawings, where:
- Figure 1: shows a perspective view of a part of a Lidar sensor system comprising a bare die laser diode device, and in accordance with prior art;
- Figure 2: shows a side view of a part of the sensor system according to Figure 1, i.e. in accordance with prior art;
- Figure 3: shows a perspective view of a part of a Lidar sensor system in accordance with the present disclosure;
- Figure 4: is a cross-sectional view of the Lidar sensor system according to Figure 3, as regarded along a generally transversal direction of the laser diode device;
- Figure 5: is a perspective view showing a first step of a process for manufacturing a Lidar sensor system according to the disclosure;
- Figure 6: is a perspective view showing a further step of the process for manufacturing said Lidar sensor system;
- Figure 7: is a perspective view showing a yet further step of the process for manufacturing said Lidar sensor system; and
- Figure 8: is a flowchart showing the principles of a process for manufacturing a Lidar sensor system.

### DETAILED DESCRIPTION

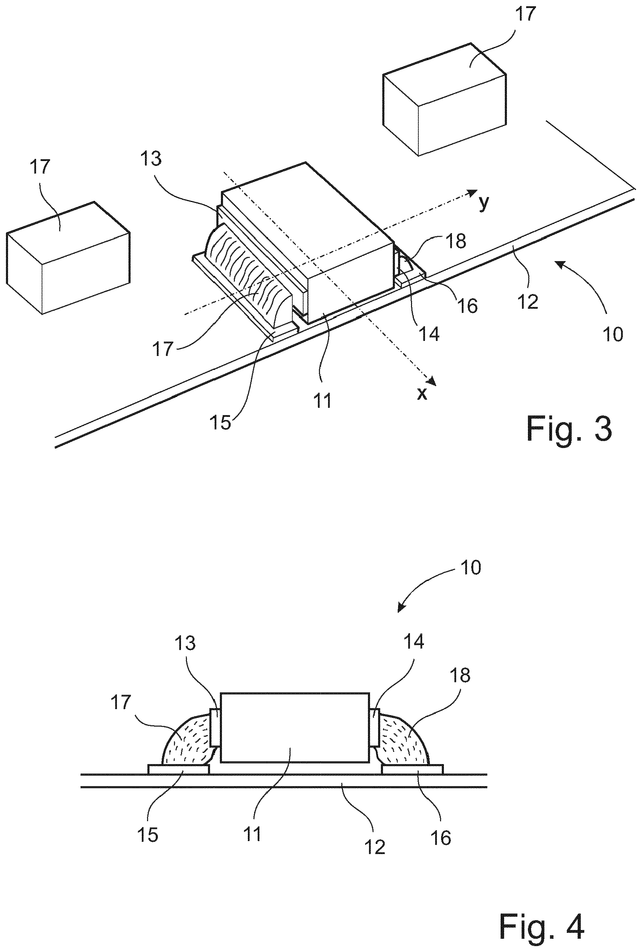

In Figure 3, there is shown schematically a perspective view of a part of a Lidar sensor system 10, which according to an embodiment can be used as a sensor system in a vehicle. More precisely, and according to an embodiment, the Lidar sensor system 1 can be used in a manner as initially described, i.e. for detecting particular predefined objects, possible obstacles, road and lane markings, road signs and other similar objects. As mentioned initially, such a Lidar sensor system 10 can suitably be used, for example, in connection with autonomous vehicles.

Such a Lidar sensor system 10 can for example be mounted in a suitable manner on the inside of a windshield in a vehicle (not shown in the drawings). This means that the field of view of the Lidar sensor system 10 is ahead of the vehicle in question.

The Lidar sensor system 10 is particularly intended to be used on road vehicles, primarily in the form of cars, trucks and buses and similar vehicles, but can according to different embodiments be used in other vehicles. Alternatively, the Lidar sensor system 10 can be used in non-vehicle applications.

As shown in Figure 3, the Lidar sensor system 10 is based on the use of a laser diode device 11 which is mounted on a carrier element 12, suitably in the form of a printed circuit board. The laser diode device 11, i.e. which constitutes a light-emitting chip, is according to an embodiment in the form of a bare die laser diode device. This corresponds to a laser diode device which is not encapsulated and which is consequently free from a packaging or enclosure. The bare die is a pure component, normally of silicon, which constitutes the actual laser device. As mentioned initially, such an embodiment is advantageous due to the fact that it allows a reduction of the size of the Lidar sensor system 10.

Furthermore, with reference to Figure 3, the laser diode device 11 is provided with a first contact terminal 13 and a second contact terminal 14. The terminals 13, 14 are in the form of two conductive and generally vertically arranged layers which are positioned on each side of the laser diode device 11. More precisely, and according to an embodiment shown in Figure 3, the contact terminals 13, 14 are positioned on each side of the laser diode device 11 and on each side of a generally vertical plane which extends along a longitudinal direction x through the laser diode device 11.

Also, the carrier element 12 is formed with a first contact surface 15 and a second contact surface 16 which are configured for being electrically connected to the first contact terminal 13 and the second contact terminal 14, respectively.

The carrier element 12 is generally also configured for supporting various other electrical components 17 forming part of the Lidar sensor system 10, such as a power supply, filters, detector devices, and according to various embodiments also further discrete components such as capacitors, resistors and other similar devices.

Furthermore, the laser diode device 11 according to the embodiment shown in Figure 3 is configured with a square, or alternatively rectangular, cross-section as regarded along a generally vertical plane which extends along a transversal direction y through the laser diode device 11. Suitably, the laser diode device 11 also has generally vertical side surfaces. The first contact terminal 13 and the second contact terminal 14 are mounted on each one of these generally vertical side surfaces, as indicated in Figure 3 and Figure 4. This means that said contact terminals 13, 14 are configured as layers being oriented along a generally vertical direction.

According to an embodiment, the Lidar sensor system 10 is arranged in a manner so that the laser diode device 11 is positioned with its contact terminals 13, 14 close to each corresponding contact surface 15, 16 forming part of the carrier element 12. In this manner, the laser diode device 11 can be electrically connected to the contact surfaces 15, 16 of the carrier element 12 by means of a soldering process, as will be described below.

Alternatively, the contact terminals 13, 14 can be configured so that they are in direct contact with the corresponding contact surface 15, 16 even before these components are soldered together.

More precisely, as shown in Figure 3 and furthermore also in Figure 4 which is a cross-sectional view of a part of the Lidar sensor system 10 along a generally vertical plane in a transversal direction y of the laser diode device 11, the first contact terminal 13 is mounted to and electrically connected to the first contact surface 15. In a corresponding manner, the second contact terminal 14 is mounted to and electrically connected to the second contact surface 16. This means that each one of the contact terminals 13, 14 are fixed to, i.e. mechanically connected to, its corresponding contact surface 15, 16. According to an embodiment, these connections are carried out by means of soldering. More precisely, the soldering process results in a first deposition 17 of solder paste connecting the first contact terminal 13 and the first contact surface 15, and furthermore a second deposition 18 of solder paste connecting the second contact terminal 14 and the second contact surface 16. In this manner, each contact terminal 13, 14 will be soldered to a corresponding contact surface 15, 16.

In summary, and with reference to Figure 3 and Figure 4, the disclosure relates to a Lidar sensor system 10 comprising a laser diode device 11 and further electrical components 17 which together constitute the complete sensor system 10. Furthermore, the system 10 comprises a carrier element 12 for supporting said laser diode device 11 and said further electrical components 17. According to an embodiment, the carrier element 12 is a printed circuit board.

Furthermore, the carrier element 12 is provided with two contact surfaces 15, 16 which are associated with two corresponding contact terminals 13, 14 forming part of said laser diode device 11. Also, the laser diode device 11 is configured so that said contact terminals 13, 14 are positioned on each side of said laser diode device 11, and that each one of said contact terminals 13, 14 is mounted to and electrically connected to a corresponding one of said contact surfaces 15, 16.

As indicated in particular in Figure 4, it is not strictly necessary that the contact terminals 13, 14 are in contact with the corresponding contact surface 15, 16 before a soldering process is carried out. In fact, the soldering process ensures that the relevant electrical connections are obtained.

It should be noted that an advantage of the disclosure, as compared with prior art (see Figure 1 and Figure 2), is that there is no need for any bond wires connecting any of the contact terminals 13, 14 with other parts or components of the Lidar sensor system 10.

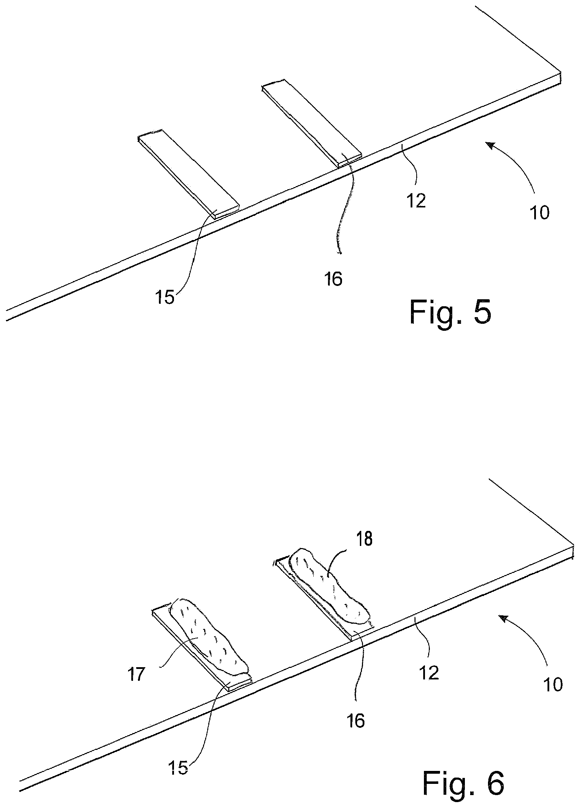

According to an embodiment, the disclosure also relates to a method for manufacturing a Lidar sensor system 10 of the above-mentioned kind. An embodiment will now be explained with reference to Figures 5, 6 and 7.

Initially, and with particular reference to an embodiment as disclosed in Figure 5, the method comprises a step of providing a carrier element 12 for supporting a laser diode device 11 (which as such is shown in Figure 3 and Figure 4). The carrier element 12 is also arranged for supporting further electrical components. However, no such further components are shown in Figure 3 and Figure 4. For simplicity, it can be assumed that such further components will be mounted after the laser diode device 11 has been mounted.

It should be noted that the carrier element 12 is provided with two contact surfaces 15, 16 which are configured so as to be associated with the corresponding contact terminals (indicated with reference numerals 13, 14 in Figure 3 and Figure 4) of the laser diode device 11.

Figure 5 shows the Lidar sensor device 10 before the laser diode device 11 is mounted. More precisely, Figure 5 shows an embodiment in which the contact surfaces 15, 16 are aligned with the assumed positions of the corresponding contact terminals 13, 14 on the laser diode device 11.

Generally, the method according to the embodiment comprises a step of arranging the contact surfaces 15, 16 of the carrier element 11 in a manner so that they can be electrically connected to a corresponding one of the contact terminals 13, 14 of the laser diode device 11. Also, the laser diode device 11 is configured so that its contact terminals 13, 14 will be positioned on each side of the laser diode device 11.

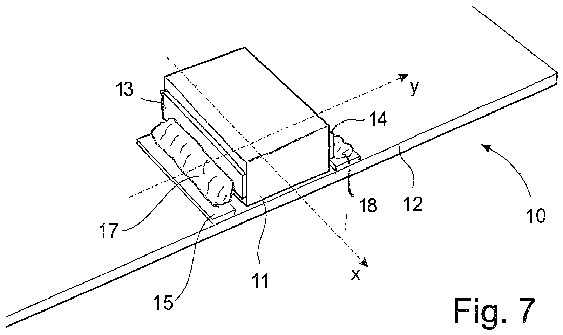

Before mounting the laser diode device 11, there is according to an embodiment provided a suitable amount of solder paste 17 on the first contact surface 15 and a suitable amount of solder paste 18 on the second contact surface 16. This is shown in Figure 6. In a subsequent step, shown in Figure 7, the laser diode device 11 is positioned between the first contact surface 15 and the second contact surface 16. Due to the use of the solder paste 17, 18, the laser diode device 11 will stick to the carrier element 12 in its intended position so that it does not fall off the carrier element 12.

In this manner, the complete arrangement according to Figure 7 comprises a carrier element 12 with a laser diode device 11 which is positioned along a longitudinal direction x and a transversal direction y and which is ready for a subsequent soldering step in which the carrier element 12 is heated to a suitable temperature at which the solder paste will melt and electrically connect the first contact surface 15 with the first contact terminal 13, and connect the second contact surface 16 with the second terminal 14. A process for soldering an electrical component by heating a carrier element with said electrical component is generally known to the skilled person. For this reason, it is not described in detail here.

After the soldering step, the laser diode device 11 is electrically and mechanically connected to the contact surfaces 15, 16 of the carrier element 12.

In some embodiments, it is useful with additional means for fixing the laser diode device 11 to the carrier element 12. In this manner, it can be ensured that the melted solder paste does not cause the laser diode device 11 to move or to be displaced from its intended position. Such means can include an adhesive for attaching the laser diode device 11 to the carrier element 12. Alternatively, the carrier element 12 may be configured with a recess or similar element in which the laser diode device 11 can be fitted so as to be held in place.

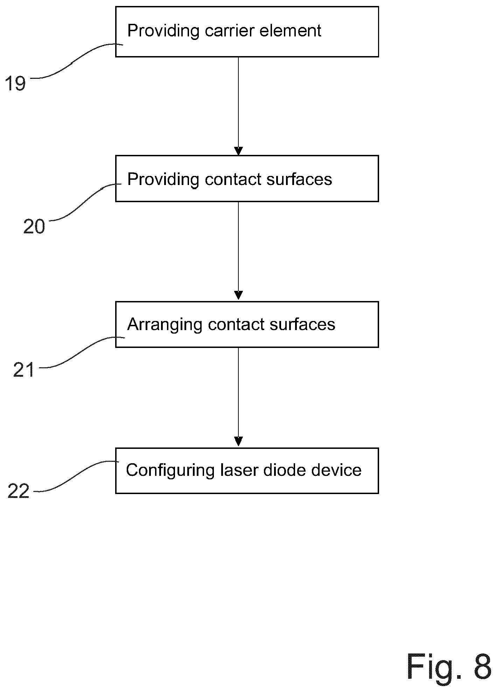

With reference to Figure 8, there is shown a flowchart of the principles of the above-mentioned method for manufacturing the Lidar sensor device 10 as described above. In an initial step, the carrier element 12 is provided for supporting the laser diode device 11, as indicated with reference numeral 19 in Figure 8. In a second step, indicated with reference numeral 20, two contact surfaces 15, 16 are provided on the carrier element 12. These contact surfaces 15, 15, (see also Figure 5) are associated with the two corresponding contact terminals 13, 14 forming part of the laser diode device 11.

Next, the contact surfaces 15, 16 are arranged to be electrically connected to a corresponding one of the contact terminals 13, 14, see reference numeral 21. According to an embodiment, this is obtained by means of arranging solder paste 17, 18 on the contact surfaces 15, 16. Also, the laser diode device 11 is configured so that the contact terminals 13, 14 are positioned on each side of the laser diode device 11, see reference numeral 22.

According to an embodiment, the process comprises the above-mentioned steps of arranging the contact surfaces 15, 16 and configuring the laser diode device 11 so that its contact terminals 13, 14 are positioned on each side of the laser diode device 11, which leads to an advantageous method for manufacturing a complete Lidar sensor system.

The present disclosure is not limited to the examples above, but may vary freely within the scope of the appended claims. For example, the disclosure may relate to different types of sensor systems which can be used in vehicles or other applications.

The Lidar sensor system 10 as described can, for example, be used in a vehicle system for detection of road conditions, for speed control, for navigation, or in connection with systems for autonomous driving or similar fields of use. These fields of technology are mentioned here purely as examples.

Generally, and with reference to the appended Figure 3 and Figure 4, the present disclosure relates to a Lidar sensor system 10 comprising a laser diode device 11 and further electrical components 17, and also comprising a carrier element 12 for supporting said laser diode device 11 and said further electrical components 17. The carrier element 12 is provided with two contact surfaces 15, 16 which are associated with two corresponding contact terminals 13, 14 forming part of said laser diode device 11. Also, the laser diode device 11 is configured so that said contact terminals 13, 14 are positioned on each side of said laser diode device 11, and that each one of said contact terminals 13, 14 is mounted to and electrically connected to a corresponding one of said contact surfaces 15, 16.

By means of the Lidar sensor system 10 described above, certain advantages are obtained, for example an increased integration and also improvements of certain properties such as an improved heat dissipation and improved power management.

According to some aspects, the contact terminals 13, 14 are positioned on each side of a generally vertical plane extending along a longitudinal direction x through the laser diode device 11.

According to some aspects, the laser diode device 10 has a square or rectangular cross-section as regarded along a generally vertical plane extending along a transversal direction y through the laser diode device 10.

According to some aspects, the contact terminals 13, 14 are configured as layers being oriented along a generally vertical direction.

According to some aspects, the contact terminals 13, 14 are electrically connected to said contact surfaces 15, 16 by means of soldering, such that each contact terminal 13, 14 is soldered to a corresponding contact surface 15, 16.

According to some aspects, the carrier element 12 is a printed circuit board.

According to some aspects, the laser diode device 11 is a bare die laser diode 11.

The disclosure also relates to a method for manufacturing a Lidar sensor system 10 having a laser diode device 11 and further electrical components 17. The method comprises the following steps: providing 19 a carrier element 12 for supporting said laser diode device 11 and said further electrical components 17; and providing 20 two contact surfaces 15, 16 on said carrier element 12 which are associated with two corresponding contact terminals 13, 14 forming part of said laser diode device 11. Furthermore, the method comprises the following steps: arranging 21 said contact surfaces 15, 16 in a manner to be electrically connected to a corresponding one of said contact terminals 13, 14; and configuring 22 said laser diode device 11 so that said contact terminals 13, 14 are positioned on each side of said laser diode device 11.

According to some aspects, the method comprises positioning said contact terminals 13, 14 on each side of a generally vertical plane extending along a longitudinal direction (x) through the laser diode device 11.

## Claims

1. A Lidar sensor system (10) comprising a laser diode device (11) and further electrical components (17), and also comprising a carrier element (12) for supporting said laser diode device (11) and said further electrical components (17), said carrier element (12) being provided with two contact surfaces (15, 16) which are associated with two corresponding contact terminals (13, 14) forming part of said laser diode device (11), **characterized in that** said laser diode device (11) is configured so that said contact terminals (13, 14) are positioned on each side of said laser diode device (11), and that each one of said contact terminals (13, 14) is mounted to and electrically connected to a corresponding one of said contact surfaces (15, 16) .

2. A Lidar sensor system (10) according to claim 1, **characterized in that** said contact terminals (13, 14) are positioned on each side of a generally vertical plane extending along a longitudinal direction (x) through the laser diode device (11).

3. A Lidar sensor system (10) according to claim 1 or 2, **characterized in that** said laser diode device (10) has a square or rectangular cross-section as regarded along a generally vertical plane extending along a transversal direction (y) through the laser diode device (10).

4. A Lidar sensor system (10) according to any one of the preceding claims, **characterized in that** said contact terminals (13, 14) are configured as layers being oriented along a generally vertical direction.

5. A Lidar sensor system (10) according to any one of the preceding claims, **characterized in that** said contact terminals (13, 14) are electrically connected to said contact surfaces (15, 16) by means of soldering, such that each contact terminal (13, 14) is soldered to a corresponding contact surface (15, 16) .

6. A Lidar sensor system (10) according to any one of the preceding claims, **characterized in that** said carrier element (12) is a printed circuit board.

7. A Lidar sensor system (10) according to any one of the preceding claims, **characterized in that** said laser diode device (11) is a bare die laser diode (11).

8. Method for manufacturing a Lidar sensor system (10) having a laser diode device (11) and further electrical components (17), said method comprising the following steps:
providing (19) a carrier element (12) for supporting said laser diode device (11) and said further electrical components (17); and
providing (20) two contact surfaces (15, 16) on said carrier element (12) which are associated with two corresponding contact terminals (13, 14) forming part of said laser diode device (11);
**characterized in that** said method furthermore comprises the following steps:
arranging (21) said contact surfaces (15, 16) in a manner to be electrically connected to a corresponding one of said contact terminals (13, 14); and
configuring (22) said laser diode device (11) so that said contact terminals (13, 14) are positioned on each side of said laser diode device (11).

9. Method according to claim 8, wherein said method further comprises:
positioning said contact terminals (13, 14) on each side of a generally vertical plane extending along a longitudinal direction (x) through the laser diode device (11).
